# EUROPEAN PATENT APPLICATION

(11) **EP 0 654 831 A2**
(43) Date of publication of application: **24.05.1995**
(21) Application number: 94308381.6
(22) Date of filing: 14.11.1994
(51) Int. Cl.: H01L 31/18, H01L 31/0296

(54) **Method of manufacturing solar cell**

(30) Priority: 18.11.1993 JP 314478/93
(71) Applicant: MATSUSHITA ELECTRIC INDUSTRIAL CO., LTD., Kadoma-shi, Osaka-fu 571 (JP)
(72) Inventor: Aramoto, Tetsuya, Ikuno-ku, Osaka, 544 (JP); Nakayama, Nobuo, Hirakata-shi, Osaka, 573 (JP); Omura, Kuniyoshi, Higashiosaka-shi, Osaka, 579 (JP); Murozono, Mikio, Hirakata-shi, Osaka 573 (JP)
(74) Representative: Crawford, Andrew Birkby

(57) **Abstract**

A method of manufacturing a solar cell comprising the step of forming a layer of n-type compound semiconductor, a layer of p-type compound semiconductor, and a layer of electrode on a glass substrate, wherein one of said step of forming the layer of compound semiconductor layer comprises preparing a paste by mixing a raw semiconductor material and a viscous agent, applying said paste, drying said paste to harden, and burning said paste, and giving vibration to said substrate while or after the application of the paste, to remove the bubbles in the pastes resulting in a semiconductor layers, smooth, dense and having good adherence to each other, thus realizing a solar cell with improved and uniform characteristics.

## Description

### BACKGROUND OF THE INVENTION

### Field of the Invention

This invention relates to a method of manufacturing a solar cell of compound semiconductors by way of coating and burning.

### Description of the Prior Art

In recent years, expectation for solar cells as a clean energy source has been raised, in view of the global warming, acid rain. ozone layer destruction or such environment destruction. For the wide usage of the cells improvement of the photo-electric conversion efficiency and reduction of the cost are the most important. For that purpose, solar cells of compound semiconductors of III-V group as GaAs, InP, II-VI group as CdS/Cu₂S. CdS/CdTe, or I-III-VI₂ group as CuInS₂, CuInSe₂, as well as crystalline and amorphous silicon solar cells, have been investigated in many countries of the world. Among these, solar cells of compound semiconductors of n-CdS/p-CdTe have been practiced commercially, with relatively low material cost, conversion efficiency as high as 10%, less deterioration in long run, and relatively simple manufacturing process suitable for mass production consisting of repeated printing, drying, burning (sintering or baking) resulting in possible high density arrangement on a glass plate and realization of high voltage without outer wire connection as well as large area cells.

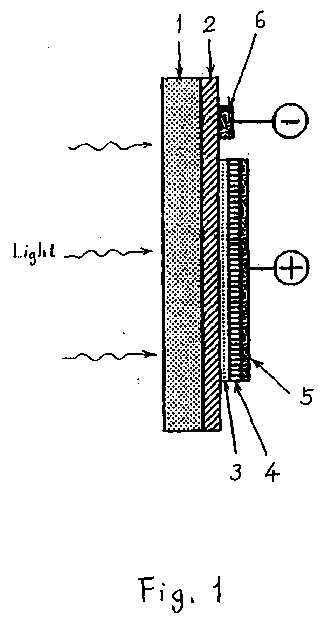

A typical solar cell of II-V group semiconductor, of which a sectional view is shown in Fig. 1, comprises a glass substrate 1 of high light transmittance and electrical insulation is provided on one surface thereof with a n-type CdS layer 2, a p-type CdTe layer 3, a current collecting carbon electrode layer 4, an Ag·In electrode which is the positive terminal 5, and an Ag·In electrode which is the negative terminal 6 formed by stacking with printing and baking for each step. Usually, further, although not shown in the figure, thus prepared solar cell element is provided. on both the Ag·In electrodes, with a copper paste deposited, dried and baked for easy soldering of lead wires. The remaining part is then covered all over with a passivation layer of a thermosetting resin such as epoxy deposited and baked.

Light, including that of the sun, falls on the surface of the glass substrate 1 opposite to the surface having the above solar cell element layers, to generate electric power by photoelectric conversion.

As the substrate a heat-resistant barium borosilicate glass is employed, which has very low alkaline metal content and high softening point.

In the manufacturing of the compound semiconductor solar cell by coating and burning method, it is important that each of the n-type compound semiconductor layer, p-type compound semiconductor layer, and electrode layer must have uniform thickness, smooth surface, and no pin-hole. Especially, if the n-type CdS semiconductor layer laied directly on the substrate is uniform, smooth and non-porous, the adherence of the layer to the substrate is improved, resulting in increase of the light transmittance, decrease of the sheet resistance, and, further, increase of the photo-current and improvement of the characteristics of the cell.

Conventionally, to obtain such a layer, the paste of the powdered compound semiconductor or elements therefor and the electroconducting agent and a viscous agent mixed together was kept under reduced pressure to remove bubbles therein and, after the deposition, the substrate was held horizontally at about 50°C or such, which was lower than the drying temperature of the viscous agent, to reduce the viscousity of the viscous agent and uniformly precipitate the raw material powders to bring about high density. However, if the bubbles were removed from the paste before painting, it sometimes happened in the painting process in screen printing that bubbles were brought in from the surrounding atmosphere to results in uneven deposition or pin-holes. Also, with only the heat treatment after painting, the raw material powders did not always uniformly precipitate, and the bubbles were not sufficiently removed, resulting in each layer not flat, not of uniform thickness. The pin-holes left after painting and baking in the layers caused the increase of sheet resistance; especially, if pin-holes were formed in the p-type CdTe layer, the carbon particles of the carbon electrode layer laid thereon penetrated into the pin-holes up to the CdS layer under the CdTe layer, to cause internal short circuitting or current leakage, fatally damaging the battery performance.

### SUMMARY OF THE INVENTION

It is an object of the present invention to provide a new method of manufacturing compound semiconductor solar cells comprising n-type and p-type compound semiconductor and electrode layers having improved performance, and uniform characteristics, and low production cost as brought about by the layers without pin-holes but with uniform thicknesses and smooth surfaces.

To obtain the above object, a method of manufacturing a solar cell according to the present invention comprises step of forming a layer of n-type compound semiconductor, a layer of p-type compound semiconductor, and a layer of electrode on a glass substrate, wherein one of said step of forming the layer of compound semiconductor comprises preparing a paste by mixing a raw semiconductor material and a viscous agent, applying said paste, drying said paste to harden, and burning said paste, and giving vibration to said substrate while or after the application of the paste.

### BRIEF DESCRIPTION OF THE DRAWINGS

Fig. 1 is a schematic sectional view of a II-VI group compound semiconductor solar cell of n-CdS/p-CdTe type.

Fig. 2 is a microscopic photograph of a section of sintered CdS layer on a glass substrate.

Fig. 3 are graphs of the open circuit voltages, short circuit currents, fill factors, and intrinsic photo-electric conversion efficiencies of solar cells fabricated according to the present invention as well as to the conventional method.

### DETAILED EXPLANATION OF THE INVENTION

An example of the method of manufacturing a II-VI group compound semiconductor solar cell according to the present invention are explained referring to Fig. 1.

A paste was prepared by mixing cadmium sulphide (CdS) fine powder, cadmium chloride (CdCℓ₂) and propylene glycol (PG), the CdCℓ₂ being a flux and the PG being a viscous agent.

The paste was applied on a substrate of barium borosilicate glass by screen printing to form a coating layer of 60µm thickness.

The glass substrate was given vibration of 20 µm amplitude, 28kHz ultrasonic frequency by contacting a horn of piezoelectric vibrator on the outer end of the substrate for 5 seconds, whereby the roughness of the layer due to the screen net disapeared and the bubbles in the layer were removed, as observed. The substrate with the layer was dried in the atmosphere at 120°C (PG was removed by vaporization), and sintered at 690°C.

A substrate with the layer was fabricated by similar method but without the application of vibration.

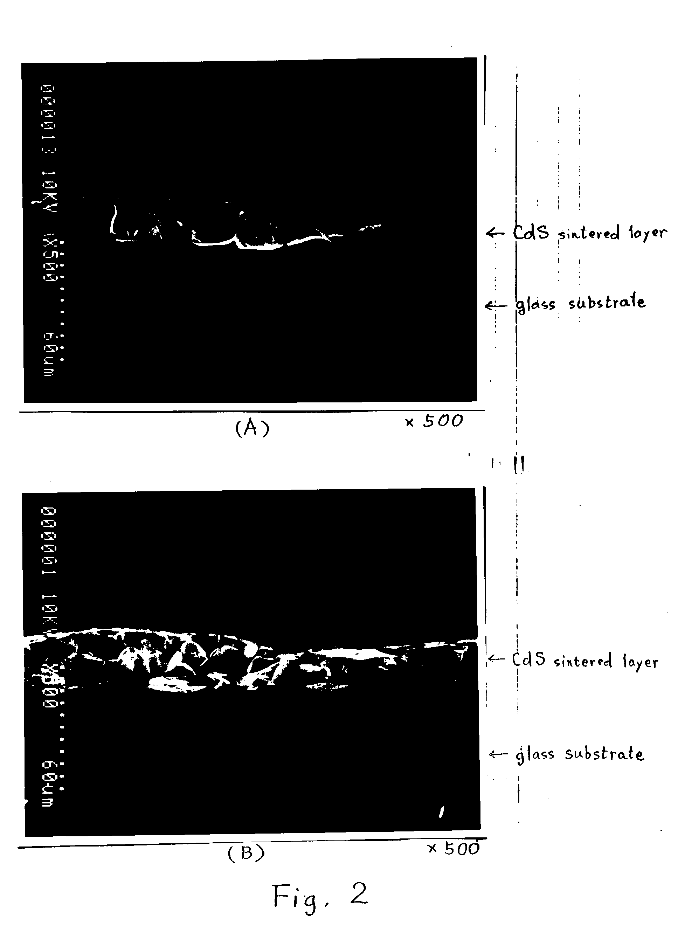

Of the compound semiconductor layers of the two kinds of samples, the light transmittance and sheet resistance were measured and microphotographes of the sections (×500) were taken. The results are shown in Table 1 and Fig. 2.

**Table 1**

| | CdS layer formed according to the present invention | CdS layer formed without vibration |
|---|---|---|
| Light transmittance(%) (λ=0.7µm) | 63 | 60 |
| Sheet resistance(Ω/cm²) | 28 | 33 |

As is observed in Fig.2, the CdS layer (B) on the substrate prepared without vibration has projections and dents on the surface and void spaces and/or pin-holes and the thickness is not uniform. Moreover, it is not sufficiently adherent to the substrae. On the contrary, the CdS layer of the sample (A) fabricated with vibration has little voids and/or pin-holes and uniform thickness as well as a smooth surface, sticking fully to the substrate. Numerically, Table 1 indicates improvements of the light transmittance by 5% and reduction of the sheet resistance by 15%. Thus it is expected the CdS layer with the vibration would have superior characteristics as the window material of solar cells.

Next, Cd·Te paste was prepared by kneading well a equi-mol powder mixture of cadmium (Cd) and tellurium (Te) with addition of CdCℓ₂ and PG, and the paste was applied on the above CdS sintered layer by screen printing by 30µm thickness, dried in the atmosphere, and sintered at 620°C, to form the CdTe layer.

Then, a carbon paste, prepared by kneading carbon powder and a viscous agent of organic solvent solution of a resin, is applied on the CdTe layer, to make the CdTe layer a p-type semiconductor having a n-CdS/p-CdTe heterojunction with the CdS layer, and to form a electricity collecting electrode.

Further, the carbon electrode layer 4 and the CdS layer 2 were provided with a positive terminal 5 and a negative terminal 6 of Ag·In by depositing Ag·In paste with screen printing and drying and baking, the Ag·In paste being prepared by kneading powders of silver(Ag) and indium(In) with a viscous agent of an organic solvent solution of a resin.

On the positive and negative electrodes 6 and 5 of Ag·In, copper paste was applied by screen printing. and dried and baked, and further, on the other parts of the cell a passivation layer was likewise applied by printing, and dried and baked, to finish the process. The sinterings or bakings in the above processes were made in a nitrogen atmosphere.

In the following is described the effect of vibration given to the glass substrate when, in the above described manufacturing process of compound semiconductor solar cell, the pastes of the mixtures of the powdered n-type and p-type compound semiconductor materials and electric conductive agent and a viscous agent were applied to form the n-type and p-type layers and electrode layers on the substrate.
A; A sample of a cell fabricated with semiconductor and electrode layers dried and burned after the application of the paste on the substrate without giving vibration according to the prior art.
B; A sample fabricated giving vibration to the substrate after the application of CdS paste only, no vibration in the other processes.
C; A sample fabricated giving vibration after the application of CdTe only, no vibration in the other processes.
D; A sample fabricated with vibration after the application of the carbon paste only, no vibration in the other processes.
E; A sample prepared giving vibration to the substrate after application of CdS paste, CdTe paste, and carbon paste, with further drying and burning.

The vibration was given by 20µm amplitude and 22kHz frequency for 10 seconds by pressing the hone of the ultrasonic oscillator to the reverse side of the glass substrate; the reverse side means the surface on which the semiconductor layers are not piled. The other conditions were the same.

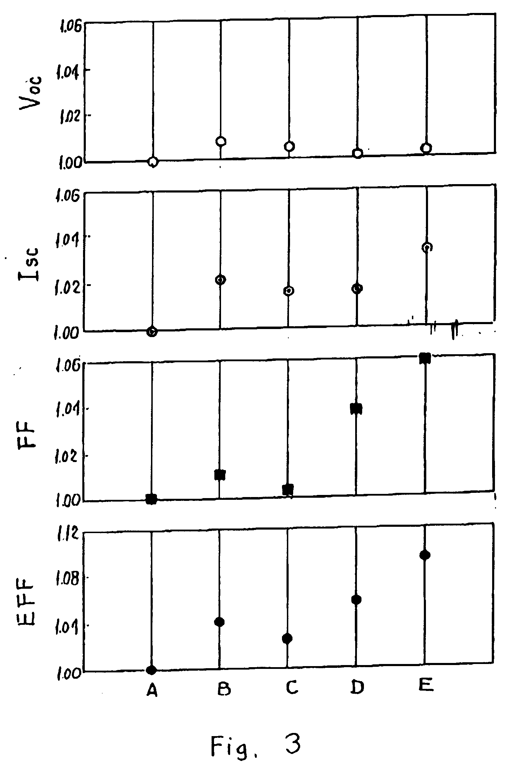

Of solar cells of these samples, open circuit voltages(V_{OC}), short circuit current (I_{SC}), fill factor (FF), and intrinsic photo-electric conversion efficiency (EFF) were measured, with the results shown in Fig.3 as the relative values to the values for sample A taken as 1.00.

From the measurements for the sample B shown in Fig.3, it is considered that the vibration after the CdS application has brought, by the removing of the paste bubbles, and smoothing of the film surface and by improvement of the adhesivity between the CdS layer and the substrate, with the resultant light transmittance increase and surface resistance reduction, improvement of I_{SC}. and, through the reduction of pin-hole number at the junction, improvements of V_{OC} and FF.

From the data for the sample C, it is considered that the vibration after the Cd·Te paste application has led to the improvement of V_{OC}, I_{SC}, and FF as the results of the growing or orientation increasing of CdTe grains or such improvements of thef ilm quality.

The measurements for the sample D show the contribution of the vibration after the carbon paste application to the improvement of I_{SC} and FF. It is thought that the contact resistance between the carbon electrode layer and the CdTe layer has been reduced by the vibration.

Lastly, from the data of the sample E, it is clear that about 10% increase of EFF compared to sample A has been obtained by the combined effect of the vibrations after each of the applications of CdS, Cd·Te and carbon pastes.

Thus, it is understood that the characteristics of the solar cells are improved by a simple measure to give vibration to the glass substrate after the applications of the pastes, without accompanying any considerable change of the process or manufacturing installation.

The method of application of the various pastes is not confined to the screen printing as referred to in the above explanation. Various other methods can be employed; plotting printing to push out paste from a nozzle and print a figure of a desired pattern on a glass substrate adjusting the distance between the tip of the nozzle and the surface of the substrate to change the paint thickness; relief and intaglio printing; spray printing to spray paste with a spray gun shielding the non-desirous part by a mask.

Table 2 shows how the spread of unevennes of the surface (the difference between the maximum thickness and the minimum thickness) and the yields in production change depending upon employing or not the ultrasonic treatment on every layer of cells. As is observed, by the vibration after the paste application

**Table 2**

| Printing | Without ultrasonic treatment | | With ultrasonic treatment | |
|---|---|---|---|---|
| | Spread of unevenness(µm) | Yield(%) | Spread of unevenness(µm) | Yield(%) |
| Screen | 35 | 92 | 8 | 95 |
| Plotting | 15 | 85 | 9 | 89 |
| Relief | 21 | 72 | 4 | 82 |
| Intaglio | 26 | 82 | 9 | 90 |
| Spray | 18 | 74 | 12 | 91 |

similar effects can be obtained as for the the screen printing.

Instead of giving vibration to the outer circumference or the outer surface after the application of the pastes as explained above, application of vibration while printing of the paste may have the same effects.

For the application of such ultrasonic vibration, 5 to 10 seconds are sufficient, so that the application of paste with the vibration and further vibration thereafter of a short time less than 5 second is enough; no substantial elongation of manufacturing time.

Although the ultrasonic vibration given to the glass substrate while the pastes of the n-type and p-type compound semiconductor layers and electrode layer were applied or after they were applied was effective, any vibration given while the pastes were applied or after they were applied for the formation of the terminal or passivation layer did not bring about remarkable effect on the cell characteristics.

It is added that the method of the present invention, thus far explained with reference to CdS/CdTe compound semiconductor solar cell, can be applied to the formation of other compound semiconductor layers of solar cells including I-III-VI₂ group compound, for example CuInSe₂ in place of CdTe, provided the layer is formed by painting and burning.

As explained above in detail, when a solar cell is fabricated by forming n-type and p-type compound semiconductor layers, electrode layers et al. in stack on a glass substrate, the layers become free of bubbles, and the surfaces flat, if vibration is given to the glass substrate while or after the paste of the raw material and viscous agent for the layer are applied; and drying and burning thereafter bring dense layers of uniform thickness and in good contact with the next layer, and a solar cell with improved, uniform characteristics.

## Claims

1. A method of manufacturing a solar cell comprising the steps of forming a layer of n-type compound semiconductor, a layer of p-type compound semiconductor, and a layer of electrode on a glass substrate, wherein one of said step of forming the layer of compound semiconductor layer comprises:
preparing a paste by mixing a powdered raw semiconductor material and a viscous agent, applying said paste, drying said paste to harden, and burning said paste, and giving vibration to said substrate while or after the application of the paste.

2. A method of manufacturing a solar cell of Claim 1, wherein said vibration is of a ultrasonic pulse form.

3. A method of manufacturing a solar cell of Claim 1 or 2, wherein the application of the paste is performed by one method selected from the group of screen printing, plotting printing, relief printing, intaglio printing and spray printing.

4. A method of manufacturing a solar cell of Claim 1, 2 or 3, wherein the powdered raw materials for the layers of n-type and p-type semiconductors comprise elements of groups II and VI or a compound thereof.

5. A method of manufacturing a solar cell of Claim 1, 2 or 3, wherein said n-type compound semiconductor layer comprises CdS, and said p-type compound semiconductor layer comprises CdTe or CuInSe₂.

6. A method of manufacturing a solar cell of Claim 1, 2, 3, 4 or 5, further comprising a step of forming a passivation layer of resin except the portion of positive and negative terminals.
